# EUROPEAN PATENT APPLICATION

(11) **EP 4 661 379 A1**
(43) Date of publication of application: **10.12.2025**
(21) Application number: 24857707.4
(22) Date of filing: 15.03.2024
(51) Int. Cl.: H04M 1/02

(54) **ELECTRONIC DEVICE**

(30) Priority: 28.08.2023 CN 202311096896
(71) Applicant: Honor Device Co., Ltd., Shenzhen, Guangdong 518040 (CN)
(72) Inventor: LIU, Kang, Shenzhen, Guangdong 518040 (CN); HE, Haibo, Shenzhen, Guangdong 518040 (CN)
(74) Representative: Gill Jennings & Every LLP
(86) International application number: PCT/CN2024/081886
(87) International publication number: WO 2025/044154

(57) **Abstract**

An electronic device is provided. The electronic device may include any one of a handheld device, an in-vehicle device, a wearable device, a terminal device, connected to a wireless modem, a cellular phone, a smart phone, a personal digital assistant, a computer, a tablet computer, a handheld computer, and the like. In embodiments of this application, a software matting algorithm does not need to be used when a main board processes an electrical signal transmitted by an ambient light sensor so that a computing method is simple. In addition, a corresponding location of a transparent cover plate does not need to be painted with black ink, thereby simplifying a processing process of the electronic device and reducing use costs.

## Description

This application claims priority to Chinese Patent Application No. 202311096896.3, filed with the China National Intellectual Property Administration on August 28, 2023 and entitled "ELECTRONIC DEVICE", which is incorporated herein by reference in its entirety.

### TECHNICAL FIELD

Embodiments of this application relate to the field of communication device technologies, and in particular, to an electronic device.

### BACKGROUND

An ambient light sensor is usually arranged in an electronic device. The ambient light sensor is mainly configured to sense ambient light intensity, and can output an electrical signal to a main board of the electronic device. The main board automatically adjusts brightness of a display screen based on the electrical signal, thereby achieving a function of reducing power consumption of the device and prolonging a service life of the device, and also achieving a function of protecting eyes. In view of this, the ambient light sensor is widely used in electronic devices such as a mobile phone and a computer.

Currently, a mainstream development direction of the display screen of the electronic device is a large screen-to-body ratio, which limits a location arrangement location of the ambient light sensor to some extent. Therefore, how to arrange the ambient light sensor to reduce impact on a display region of the display screen as much as possible is one of important technical problems concerned by a person skilled in the art.

### SUMMARY

An embodiment of this application provides an electronic device with simple software computing and a simple processing process.

An embodiment of this application provides an electronic device, including a middle frame, a display screen, and an ambient light sensor. The display screen is fixed to a side of the middle frame. The display screen includes a transparent cover plate and a display module. The display module includes a plurality of superposed functional layers, and the display module includes a first body portion and a second body portion that are connected with each other. The first body portion forms a display region, the second body portion forms a non-display region, the second body portion includes a first subregion, a sub-body portion includes at least one of the functional layers, and the sub-body portion has light transmittance with a predetermined value. To be specific, the first subregion is a part of the second body portion that has the functional layer and can transmit light, and a quantity of functional layers in the first subregion may be determined based on the light transmittance. The first subregion may be a part of the second body portion, or may be the entire second body portion.

The middle frame has a cavity. The ambient light sensor is mounted inside the cavity. The ambient light sensor is located at a side of the first subregion facing away from the transparent cover plate. The ambient light sensor can detect external light passing through the first subregion. In other words, after passing through the first subregion, the external light can enter an internal cavity, to be captured by the ambient light sensor.

In this embodiment of this application, according to the electronic device, after passing through the transparent cover plate and the first subregion, the external light can be transmitted to the ambient light sensor. The ambient light sensor converts a detected optical signal into an electrical signal and transmits the electrical signal to a main board electrically connected to the ambient light sensor. The main board analyzes and processes the optical signal and then transmits a brightness adjustment instruction to adjust brightness of the display screen. Because the first subregion in this embodiment of this application does not have a light-emitting function, the first subregion does not affect the external light. Light detected by the ambient light sensor is all external light. In this way, a software matting algorithm does not need to be used when the main board processes the electrical signal transmitted by the ambient light sensor, so that a computing method is simple. In addition, the first subregion has the predetermined light transmittance to enable the external light to pass through, so that all functional layers of the first subregion do not need to be removed, thereby reducing processing difficulty of the display module.

In addition, to some extent, the first subregion may have a shield function. In this way, an electric element on a back side of the first subregion inside is not easily observed from the outside of the display screen, and a corresponding location of the transparent cover plate does not need to be painted with black ink, thereby simplifying a processing process of the electronic device and reducing use costs.

In addition, the second body portion in this embodiment of this application may not occupy top space of the display screen, so that a width of a black border of the display screen may be reduced, thereby facilitating improvement of a screen-to-body ratio. The screen-to-body ratio is a ratio of an area of the display region of the display screen to a projection area of the transparent cover plate of the display screen. A larger screen-to-body ratio indicates a better image display effect of the electronic device.

In an example, the ambient light sensor includes a photo sensitive element, configured to detect the optical signal. A projection of the photo sensitive element onto a plane of the display screen is located within a range of the first subregion. In other words, the photo sensitive element may be located within coverage of the first subregion. For example, the photo sensitive element is located right behind the first subregion. In this way, a field of view (Field of View, FOV) of the ambient light sensor can be improved, thereby improving reliability of detection by the ambient light sensor.

In an example, a light homogenizing plate is further arranged between the second body portion and the ambient light sensor, and a function of the light homogenizing plate is to evenly emit the external light entering the first subregion to a side of the ambient light sensor. After entering through the first subregion, the external light is first projected onto a surface of a side of the light homogenizing plate facing the display module. Then, the external light is evenly dispersed after passing through the light homogenizing plate, to obtain a large light outlet surface on a side of the light homogenizing plate facing the ambient light sensor, thereby expanding the field of view of the ambient light sensor, and further improving reliability of detecting the external light by the ambient light sensor.

In an example, the light homogenizing plate includes a light homogenizing film, and the light homogenizing film is adhered to be fixed to the middle frame or the display module. The light homogenizing film has a small thickness, and occupies small space, thereby facilitating mounting of another electronic component inside the electronic device, and satisfying a requirement for lightening and thinning design of the electronic device.

In an example, the display module further includes an SCF layer. The SCF layer is located on a surface of the functional layer facing away from the transparent cover plate. The SCF layer usually has poor light transmittance performance. Therefore, a first through hole is provided in at least a partial region of the SCF layer corresponding to the first subregion, and the light homogenizing plate is located between the first through hole of the SCF layer and the ambient light sensor. In this way, the external light successively passes through the first subregion and the first through hole to reach the ambient light sensor. The SCF layer facilitates rapid heat dissipation of the display module, thereby ensuring operation reliability of the display module.

In an example, under a condition of light having a wavelength of 550 nm, the light transmittance of the first subregion ranges from 2% to 4%. When the light transmittance falls within the foregoing range, detection on external light by the ambient light sensor can be satisfied, and the second body portion also has a good function of concealing an overall appearance, that is, an electronic component located at a back side of the second body portion is not easily observed from the outside of the electronic device, and the transparent cover plate does not need to be painted with ink, thereby simplifying the processing process of the electronic device, reducing the costs, and providing a good overall appearance of the electronic device.

In an example, in addition to the SCF layer, the display module further includes a plurality of other functional layers between the SCF layer and the transparent cover plate. A part of the second body portion that does not require light to pass through is defined as a second subregion, and the second subregion includes the SCF layer and functional layers located between the SCF layer and the transparent cover plate. In this way, the first subregion may be obtained by removing the SCF layer, and the SCF layer in the second subregion does not need to be removed. Therefore, an area of the SCF layer is large, thereby improving a heat dissipation capability; and the second subregion also has a strong capability of shielding the electronic component inside the electronic device.

In an example, the display module may be an OLED display module, the functional layers include an OLED layer, and the OLED layer includes a first part and a second portion that are connected with each other. The first part is provided with a plurality of light-emitting diodes, to form the display region. The second part may have two arrangement manners:

In a first arrangement manner, the second part has no light-emitting diode, the first body portion includes the first part, and the second body portion includes the second part. In other words, the second body portion has no light-emitting diode.

In a second arrangement manner, the second part is also provided with a light-emitting diode, but the light-emitting diode in the second part is always in a non-light-emitting state. That the light-emitting diode in the second part is in the non-light-emitting state may be controlled by software or hardware. The OLED display module has good use performance, so that arrangement of a flexible screen can be implemented. In addition, in this embodiment of this application, the first part and the second part of the OLED layer are properly arranged, so that the ambient light sensor detects the external light without changing other functional layers. The functional layers in the first body portion and the second body portion may be completely the same, and only the arrangement or control of the first part and the second part of the OLED layer slightly differs, thereby further reducing assembly and a processing process of the display module.

In an example, the functional layers in the first subregion may include, but are not limited to, a polarization layer, a touchscreen layer, a thin film field-effect transistor layer, an encapsulation layer, and a substrate. The first subregion may include layers of the display module other than the SCF layer of the display module. Certainly, in some embodiments, a light transmittance factor may be considered, or one or more layers may be removed.

In an example, the middle frame includes a support plate. The support plate is located between the display module and the ambient light sensor. The support plate is located at a side of the display module away from the transparent cover plate, may be configured as a cabin body wall for accommodating the display module, and may also be configured as a supporting structure for another component like the ambient light sensor. A second through hole is provided on the support plate, and the external light entering through the first subregion is transmitted to the ambient light sensor through the second through hole. The support plate may isolate the display screen from another electronic component in the cavity. To be specific, the support plate divides the cavity into two cavities. The display screen is mounted in one cavity, and the another electronic component of the electronic device is mounted in the other cavity. The display screen and the another electronic component may be respectively located in independent cavities, to reduce mutual impact during operation.

In an example, the electronic device further includes a functional module unit. The functional module unit includes an optical component. The optical component is fixed to the cavity. The second body portion further has a third subregion. The third subregion includes a third through hole. The third through hole is a channel for light transmitted or received by the optical component. The optical component and the ambient light sensor are arranged in parallel along a specified direction. The specified direction is parallel to a plane of the transparent cover plate; and

The electronic device further includes a light-shielding member. The light-shielding member can block light emitted to or emitted out of the third through hole from being transmitted to the ambient light sensor.

In this embodiment of this application, the optical component and the ambient light sensor are arranged at the back side of the second body portion in a centralized manner, so that an area of the second body portion can be reduced as much as possible, and a display area of the first body portion can be improved, thereby improving a display capability of the electronic device, and facilitating improvement of the overall appearance of the electronic device. In addition, the arrangement of the light-shielding member avoids impact of working light of the optical component on the ambient light sensor, thereby facilitating reliable operation of the ambient light sensor.

In an example, the optical component is a light source component, that is, the optical component can emit light, and the light source component may be a light-emitting component like a soft light. The functional module further includes a light guide structure. The light guide structure is supported by the support plate. The light guide structure is located between the light source component and the third through hole, so that the light guide structure can guide light emitted by the light source component. The light guide structure may enable the light emitted by the light source component to propagate along a predetermined light path, thereby implementing a function required by the electronic device.

In an example, the light guide structure includes a first end surface, a second end surface, and a peripheral side wall. The peripheral side wall connects the first end surface and the second end surface. The first end surface and the second end surface respectively face the third through hole and the light source component. The light-shielding member may be a light-shielding material layer arranged on the peripheral side wall. In this way, light inside the light guide structure cannot be projected outward through the peripheral side wall, to prevent the light inside the light guide structure from affecting operation of components such as the ambient light sensor, thereby improving accuracy of detection by the ambient light sensor. A material of the light-shielding material layer may be metal or non-metal that can have a light-blocking function, for example, silver or aluminum.

In this embodiment, in the manner of arranging the light-shielding material layer on the peripheral side wall, small space is occupied, and a weight is light, thereby facilitating the lightening and thinning design of the electronic device.

In an example, the first end surface covers the third through hole, and the first end surface abuts against and is in contact with the display module. The first end surface abuts against and is in contact with the display module, to prevent light from being leaked between the first end surface and the display module, thereby improving working performance of the soft light and reducing impact on normal operation of another electronic component in the cavity.

In an example, the cavity further has a main board. The ambient light sensor and the optical component are mounted on the main board and may be arranged in parallel. In this way, the ambient light sensor and the optical component may directly transmit the optical signal to a main board circuit and do not need to transmit the optical signal through a component like a wire, thereby simplifying a structure.

In an example, two functional module units are provided, optical components of the two functional module units are respectively located at two sides of the ambient light sensor, and the two functional module units and the ambient light sensor are arranged in parallel. For example, the two functional module units are the soft light and a front-facing camera respectively, and the two functional module units are respectively located at the two sides of the ambient light sensor. Correspondingly, the third subregion includes two third through holes, respectively for allowing light emitted by the soft light to pass through and light emitted to the front-facing camera to pass through. In this embodiment of this application, the ambient light sensor can make full use of space between the two optical components, so that the second body portion can be as small as possible, thereby further improving an area of the first body portion.

In an example, the optical component is at least one of a soft light or a front-facing camera.

In an example, the display region is located at a periphery of the non-display region. The display region may completely surround the non-display region. In this way, the non-display region is not located in a black border region of the electronic device, thereby reducing the width of the black border of the display screen and facilitating improvement of the screen-to-body ratio.

In an example, the non-display region is an oblong or a rectangle. In this way, the overall appearance of the electronic device is good.

### BRIEF DESCRIPTION OF DRAWINGS

FIG. 1 is a schematic diagram of a structure of an electronic device in conventional technologies;
FIG. 2 is a schematic cross-sectional view of only a relative location of a display screen and an ambient light sensor in FIG. 1 in a direction A'-A';
FIG. 3 is a schematic diagram of a structure of an electronic device according to an embodiment of this application;
FIG. 4 is a partial enlarged schematic diagram of a location A of the electronic device shown in FIG. 3;
FIG. 5 is a sectional view of a display module in the electronic device shown in FIG. 3 in a direction A1-A1;
FIG. 6 is a partial top view of the display module shown in FIG. 5;
FIG. 7 is a sectional view of a structure of a location A of the electronic device shown in FIG. 3 in a direction A1-A1;
FIG. 8 is an enlarged schematic diagram of a location C of the structure shown in FIG. 7;
FIG. 9 is an enlarged view of a structure of a location D in FIG. 8, where only some components are shown;
FIG. 10 is a rear view of an SCF layer and a display module in the electronic device in FIG. 3, where the view is a top view from a side of the SCF layer;
FIG. 11 is a schematic diagram of a structure in FIG. 4 with a display screen being removed;
FIG. 12 is a top view of the structure in FIG. 11;
FIG. 13 is a sectional view of a light guide structure and a shielding member in FIG. 4; and
FIG. 14 is a schematic diagram of a structure of a middle frame in an electronic device in FIG. 3.

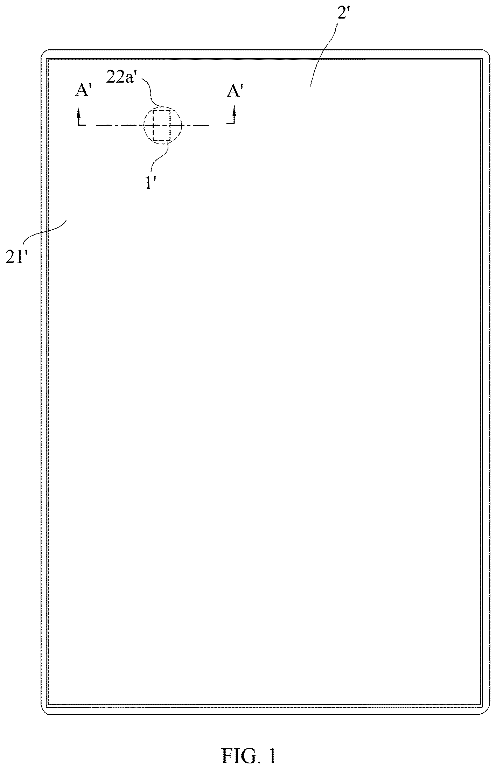

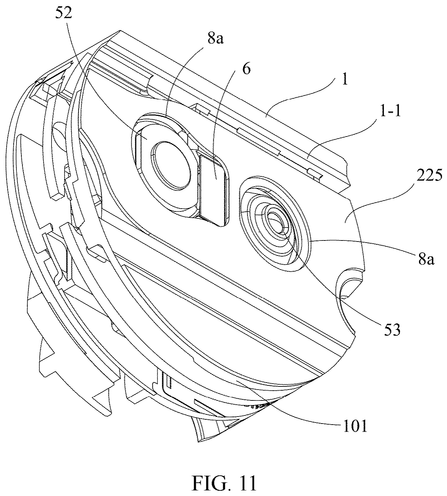

A one-to-one correspondence between reference signs and component names in FIG. 1 to FIG. 14 is as follows:
1': ambient light sensor; 2': display screen; 21': glass cover plate; 22': display module; 22a': light-transmitting through hole;
1: middle frame; 1a: cavity; 11: metal body; 12: plastic body; 101: support plate; 101a: through hole; 1-1: step surface;
2: display screen; 21: transparent cover plate; 22: display module; 22-1: first body portion; 22-2: second body portion; 22-21: first subregion; 22-22: second subregion; 22-23: third subregion; 2a: boundary line; 22a: first hole; 22b: second hole;
3: ambient light sensor; 31: photo sensitive element;
4: main board;
5: functional module unit; 51: optical component; 52: light guide structure; 521: first end surface; 522: second end surface; 523: third end surface; 53: front-facing camera module;
6: light homogenizing plate;
7: rear camera;
8: SCF layer; and
9: light-shielding member.

### DESCRIPTION OF EMBODIMENTS

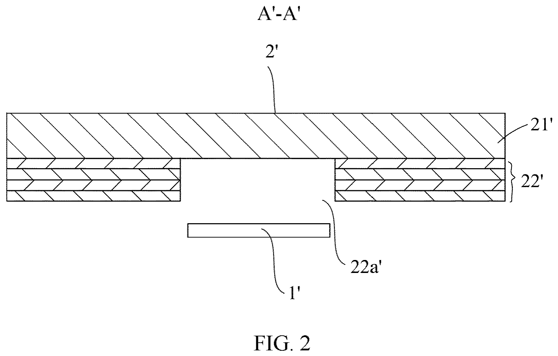

The inventor of this application makes a great deal researches on an arrangement manner of an ambient light sensor in an electronic device. It is found that an arrangement manner of a current ambient light sensor is approximately as follows: In a first manner, the ambient light sensor is arranged below a display region of a display screen, and a main board calculates current ambient light intensity based on a received electrical signal of the ambient light sensor and a pre-stored image matting algorithm, to adjust brightness of the display screen. In a second manner, an ambient light sensor 1' is integrated with a front-facing soft light or/and a front-facing camera. In FIG. 1 and FIG. 2, FIG. 1 is a schematic diagram of a structure of an electronic device in conventional technologies, and FIG. 2 is a schematic cross-sectional view of only a relative location of a display screen and an ambient light sensor in FIG. 1 in a direction A'-A'. In this manner, a display module 22' in a display region of a display screen 2' is partially cut away to provide a large light-transmitting through hole 22a'. After passing through a glass cover plate 21' of the display screen 2', external light can be transmitted to the ambient light sensor 1' through the light-transmitting through hole 22a'. To improve an aesthetic appearance of an entire machine, a corresponding location of the glass cover plate 21' needs to be painted with black ink to shield a component like the ambient light sensor 1'. In addition, a component needs to be additionally added to make the ambient light sensor 1' abut against the display screen 2' as much as possible.

In the first manner, an electrical signal of the ambient light sensor 1' needs to be combined with a software matting algorithm to adjust brightness of the display screen 2', resulting in high software complexity. In the second manner, a second through hole partially provided in the display module 22' is large, affecting a display function of the display screen 2'; and the location of the glass cover plate 21' corresponding to the ambient light sensor 1' needs to be additionally painted with the black ink, causing a complex process.

Therefore, how to solve at least one of the defects described above is a technical problem that needs to be urgently resolved by a person skilled in the art.

Based on the research finding, the inventor of this application performs explorations, conducts a large quantity of tests, and proposes an electronic device with a simple computing method and a simple process.

To enable a person skilled in the art to better understand technical solutions in embodiments of this application, embodiments of this application are further described in detail below with reference to accompanying drawings and specific embodiments.

Embodiments of this application relate to an electronic device. The electronic device may include a handheld device, an in-vehicle device, a wearable device, a terminal device, or another processing device connected to a wireless modem, and may further include a cellular phone (cellular phone), a smart phone (smart phone), a personal digital assistant (personal digital assistant, PDA) computer, a tablet computer, a handheld computer, a laptop computer (laptop computer), a video camera, a video recorder, a camera, a smart watch (smart watch), a smart wristband (smart wristband), an augmented reality (augmented reality, AR) device, a virtual reality (virtual reality, VR) device, an in-vehicle computer, and other terminal devices. A specific form of the foregoing terminal device is not specially limited in embodiments of this application. For ease of understanding, an example in which the electronic device is a mobile phone will be used below for descriptions.

The technical solutions and technical effects will be continuously introduced below by using an example in which the electronic device is the mobile phone. Certainly, a person skilled in the art should understand that the technical solutions in embodiments of this application may be applied to the mobile phone, or may be applied to an electronic device other than the mobile phone, for example, a notebook computer.

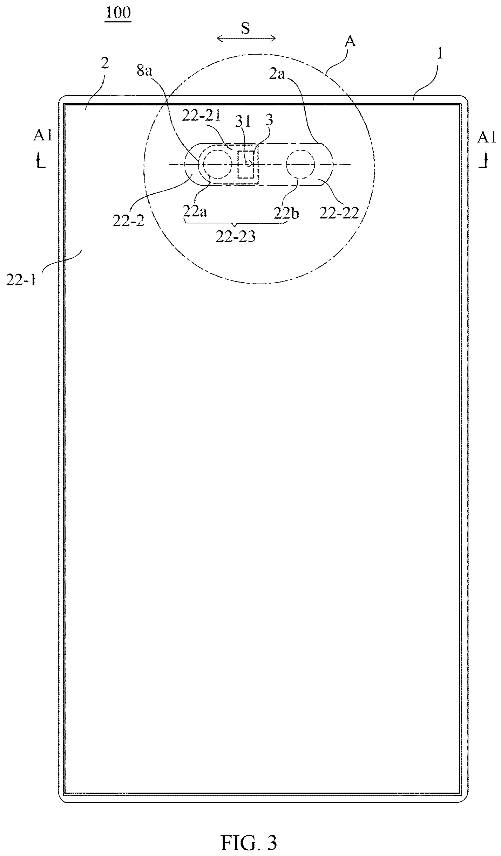

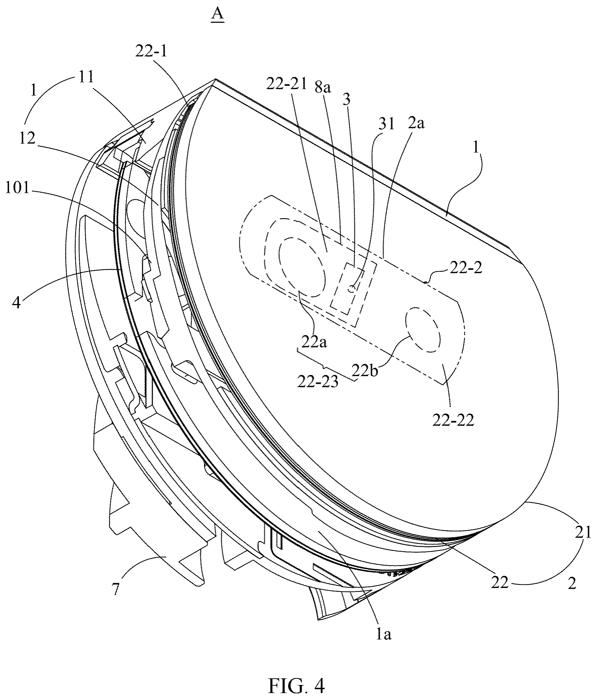

Refer to FIG. 3 and FIG. 4. FIG. 3 is a schematic diagram of a structure of an electronic device according to an embodiment of this application. FIG. 4 is a partial enlarged schematic diagram of a location A of the electronic device shown in FIG. 3.

Refer to FIG. 3. An electronic device 100 in this embodiment of this application includes a middle frame 1, a display screen 2, and an ambient light sensor 3. For a mobile phone, the middle frame 1 is a middle frame of the mobile phone. Refer to FIG. 3. A cavity 1a is enclosed by the middle frame 1. A main board 4, the ambient light sensor 3, a processor, an internal memory, a charging management module, a power management module, a battery, and other electronic components (not shown in the figure) of the electronic device 100 may be mounted inside the cavity 1a, and the display screen 2 is arranged on a side of the middle frame 1. The middle frame 1 achieves a function of supporting and protecting the electronic components.

Refer to FIG. 4 again. In this embodiment of this application, the middle frame 1 may include a metal body 11 and a plastic body 12. The plastic body 12 is formed by means of an injection molding process, the metal body 11 may be formed by means of a stamping process, and the plastic body 12 and the metal body 11 are integrated in the injection molding process. The cavity 1a has a support plate 101 that can support a related electronic component of the electronic device 100.

As shown in FIG. 4, the display screen 2 includes a display module 22 and a transparent cover plate 21. The display module 22 is configured to display an image, a video, and the like. The display module 22 may use an organic light-emitting diode (organic light-emitting diode, OLED), an active-matrix organic light-emitting diode (active-matrix organic light emitting diode, AMOLED), a flex light-emitting diode (flex light-emitting diode, FLED), quantum dot light-emitting diodes (quantum dot light emitting diodes, QLED), an electrophoretic (electrophoretic, E-Ink) technology, or the like. The transparent cover plate 21 covers an outer side of the display module, to achieve a function of protecting the display module 22. The transparent cover plate 21 may be a glass cover plate, or certainly may be another transparent material that can have a protective function. For example, the transparent cover plate 21 may be transparent polyimide. The display screen 2 may also have a touch function, that is, the display screen 2 may be a touchscreen.

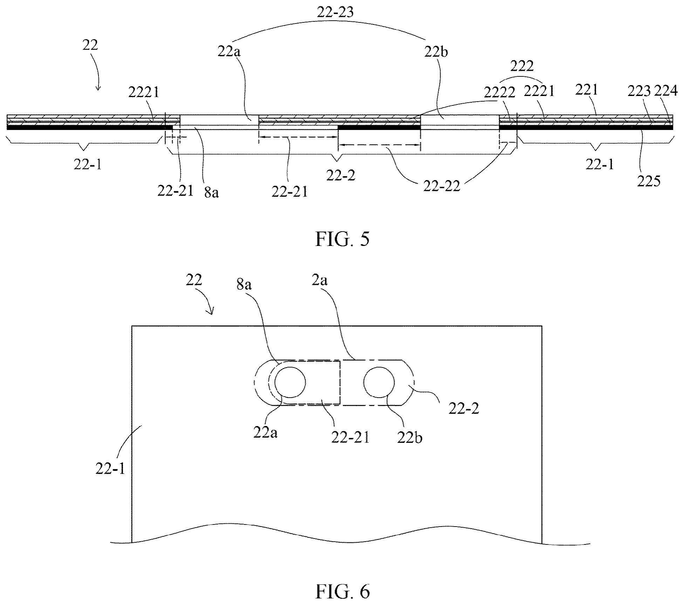

Refer to FIG. 5. FIG. 5 is a sectional view of a display module in the electronic device shown in FIG. 3 in a direction A1-A1. The display module 22 usually includes N superposed functional layers. By using the OLED as an example, the display module 22 may include, but is not limited to, the following functional layers: a polarization layer 221, a touch pad sensor (Touch Pad sensor, TP Sensor) (not shown in the figure), a thin film encapsulation (Thin Film Encapsulation, TFE) layer (not shown in the figure), an organic light-emitting diode layer 222, a thin film transistor (Thin Film Transistor, TFT) layer 223, and a back plane (back plane, BP) 224. Certainly, the quantity of the functional layers of the display module 22 may be greater than or less than the quantity of the functional layers listed in this application. A thickness of each of the layers shown in FIG. 5 does not represent an actual thickness of each of the layers, and is merely an example.

The display module 22 may be adhered to the transparent cover plate 21 through an optically clear adhesive (Optically Clear Adhesive, OCA) layer (not shown).

Refer to FIG. 5 and FIG. 6 for understanding. FIG. 6 is a partial top view of the display module shown in FIG. 5. A curve 2a in the structure shown in FIG. 6 indicates a boundary line between a first body portion 22-1 and a second body portion 22-2, and a part circled by the curve 2a is the second body portion 22-2. In this embodiment of this application, based on whether the display module 22 emits light during use, the display module 22 further includes the first body portion 22-1 and the second body portion 22-2. The first body portion 22-1 is mainly configured to display an image, a video image, and the like. To be specific, a functional layer corresponding to the first body portion 22-1 is provided with a light-emitting component, and the light-emitting component can emit light to display an image under control of a drive circuit. However, the second body portion 22-2 does not display an image or a video image during use. A corresponding functional layer of the second body portion 22-2 may not be provided with a light-emitting component or a light-emitting component in the region may be controlled to not emit light. For an OLED display module, an OLED layer 222 corresponding to the second body portion 22-2 may not be provided with a light-emitting diode or a diode in the region may be controlled to be in a non-light-emitting state. Certainly, the region may be provided with a component like a circuit that does not emit light. As shown in FIG. 4, the OLED layer 222 includes a first part 2221 and a second part 2222. The first part 2221 is located in the first body portion 22-1, and a plurality of light-emitting diodes are arranged in the first part 2221. The second part 2222 is located in the second body portion 22-2. The second part 2222 is not provided with a light-emitting diode, or the second part 2222 is provided with a light-emitting diode but the light-emitting diode in the second part 2222 is controlled to be always in the non-light-emitting state.

The OLED display module has good use performance, so that arrangement of a flexible screen can be implemented. In addition, in this embodiment of this application, the first part 2221 and the second part 2222 of the OLED layer 222 are properly arranged, so that the ambient light sensor 3 detects the external light without changing other functional layers. In this way, the functional layers in the first body portion 22-1 and the second body portion 22-2 may be completely the same, and only the arrangement or control of the first part 2221 and the second part 2222 of the OLED layer 222 slightly differs.

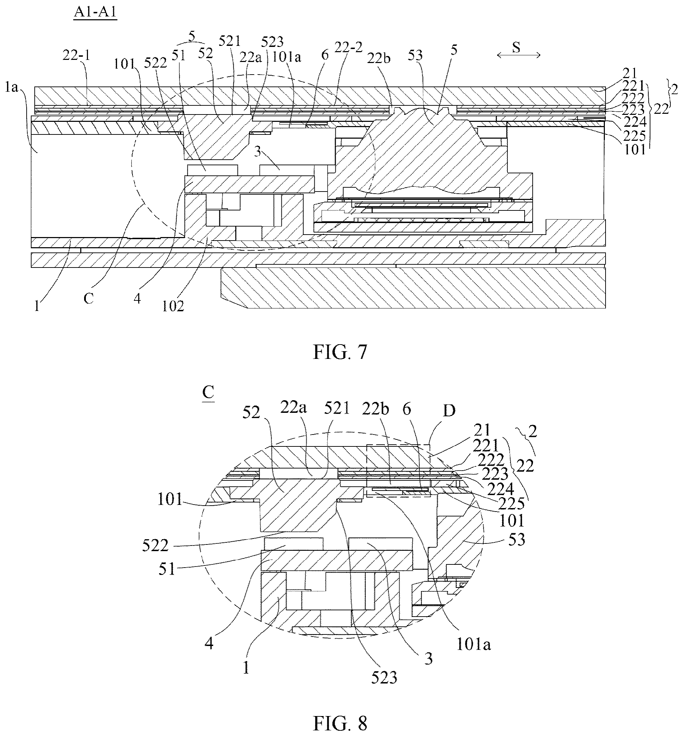

The first body portion 22-1 forms a display region on a side of the transparent cover plate 21, and the second body portion 22-2 forms a non-display region on a side of the transparent cover plate 21. The curve 2a in the figure is also a boundary line between the display region and the non-display region. The display region is located at a periphery of the non-display region, that is, the non-display region is located inside the display region, and the display region may completely surround the non-display region. Refer to FIG. 7. In this way, the non-display region is not located in a black border region of the electronic device, thereby reducing a width of the black border region of the display screen and facilitating improvement of a screen-to-body ratio. Certainly, the display region may also semi-surround the non-display region. The black border region is a region located at a periphery of the display module 22.

The non-display region may be of a shape like an oblong, a circle, or a rectangle. The oblong appearance is an aesthetic appearance.

As shown in FIG. 3 to FIG. 5, in this embodiment of this application, the second body portion 22-2 may be surrounded by the first body portion 22-1, that is, the first body portion 22-1 is at a periphery of the second body portion 22-2. A relative location of the second body portion 22-2 and the first body portion 22-1 is not limited to the location shown in the figure of this application, and may be properly selected based on a specific electronic device 100. For example, the second body portion 22-2 may alternatively be located at an edge of the display module 22, that is, the second body portion 22-2 is partially connected to the first body portion 22-1.

A functional layer of the second body portion 22-2 may be completely the same as a functional layer of the first body portion 22-1. Certainly, the functional layer of the second body portion 22-2 may alternatively be a part of the functional layer of the first body portion 22-1.

The second body portion 22-2 in this embodiment of this application further includes a first subregion 22-21, a second subregion 22-22, and a third subregion 22-23. The foregoing three regions are obtained through division mainly based on different light transmittance of the second body portion 22-2. A value of light transmittance of the third subregion 22-23 is largest, for satisfying a use requirement of an electronic component for high light transmittance. For example, the electronic component may be a soft light or a front-facing camera module 53. The third subregion 22-23 is a through hole structure, for example, a first hole 22a and a second hole 22b shown in the figure. A value of light transmittance of the first subregion 22-21 is smaller, provided that the value of the light transmittance of the first subregion 22-21 can satisfy a use requirement of the ambient light sensor 3. A value of light transmittance of the second subregion 22-22 is smallest, and the second subregion 22-22 may have all functional layers of the display module 22 and an SCF (super clean foam, SCF) layer.

In this embodiment of this application, the first subregion 22-21 includes at least one functional layer, and the first subregion 22-21 has light transmittance with a predetermined value. The value may be properly selected according to a use requirement of the ambient light sensor 3. In other words, the first subregion 22-21 is a light-transmitting part having the functional layer. Refer to FIG. 6 for understanding. A region circled by a dashed line 8a in FIG. 6 is the first subregion 22-21. A shape of the first subregion 22-21 in FIG. 6 is merely an example, and may be any shape. The first subregion 22-21 may be a part of the second body portion 22-2, or certainly may be the entire second body portion 22-2. In addition, the foregoing predetermined value is not disclosed in embodiments of this application, which does not affect understanding and implementation of the technical solutions in embodiments of this application by a person skilled in the art.

Refer to FIG. 7. FIG. 7 is a sectional view of a location A of the electronic device shown in FIG. 3 in a direction A1-A1.

In this embodiment of this application, the ambient light sensor 3 is located at a side of the first subregion 22-21 facing away from the transparent cover plate 21, and the ambient light sensor 3 can detect external light passing through the first subregion 22-21. The ambient light sensor 3 may be fixed on the main board 4, and certainly, may alternatively be fixed on the support plate 101 of the middle frame 1 which is located in the cavity 1a. The support plate 101 may be a middle plate forming a display screen mounting chamber.

In this embodiment of this application, according to the electronic device 100, after passing through the transparent cover plate 21 and the first subregion 22-21, the external light can be transmitted to the ambient light sensor 3. The ambient light sensor 3 converts a detected optical signal into an electrical signal and transmits the electrical signal to the main board 4 electrically connected to the ambient light sensor 3. The main board 4 analyzes and processes the optical signal and then transmits a brightness adjustment instruction to adjust brightness of the display screen 2. Because the first subregion 22-2 in this embodiment of this application does not have a light-emitting function, the first subregion 22-21 does not affect the external light. Light detected by the ambient light sensor 3 is all external light. In this way, a software matting algorithm does not need to be used when the main board 4 processes the electrical signal transmitted by the ambient light sensor 3, so that computing software is simple. In addition, the first subregion 22-21 has the predetermined light transmittance to enable the external light to pass through, so that all functional layers of the first subregion 22-21 do not need to be removed, thereby reducing processing difficulty of the display module.

In addition, to some extent, the first subregion 22-21 may have a shield function. In this way, an electric element on a back side of the first subregion 22-21 inside is not easily observed from the outside of the display screen 2, and a corresponding location of the transparent cover plate 21 does not need to be painted with black ink, thereby simplifying a processing process of the electronic device 100 and reducing use costs.

In addition, the second body portion 22-2 in this embodiment of this application may not occupy top space of the display screen 2, so that a width of a black border of the display screen may be reduced, thereby facilitating improvement of a screen-to-body ratio. The screen-to-body ratio is a ratio of an area of the display region of the display screen 2 to a projection area of the transparent cover plate 21 of the display screen 2. A larger screen-to-body ratio indicates a better image display effect of the electronic device 100.

As shown in FIG. 4, in this embodiment of this application, the ambient light sensor 3 usually includes a body (not shown) and a photo sensitive element 31. The body achieves a function of supporting other electronic elements, including the photo sensitive element 31, on the ambient light sensor 3. The photo sensitive element 31 may include, but is not limited to, the following elements: a photoresistor, a photosensitive diode, a phototriode, and the like. The photo sensitive element 31 mainly achieves a function of detecting an optical signal. Therefore, a projection of the photo sensitive element 31 of the ambient light sensor 3 onto a plane of the display screen 2 is located within a range of the first subregion 22-21. In this way, a field of view (Field of View, FOV) of the ambient light sensor 3 can be improved, thereby improving reliability of detection by the ambient light sensor 3. A large field of view of the ambient light sensor 3 is better.

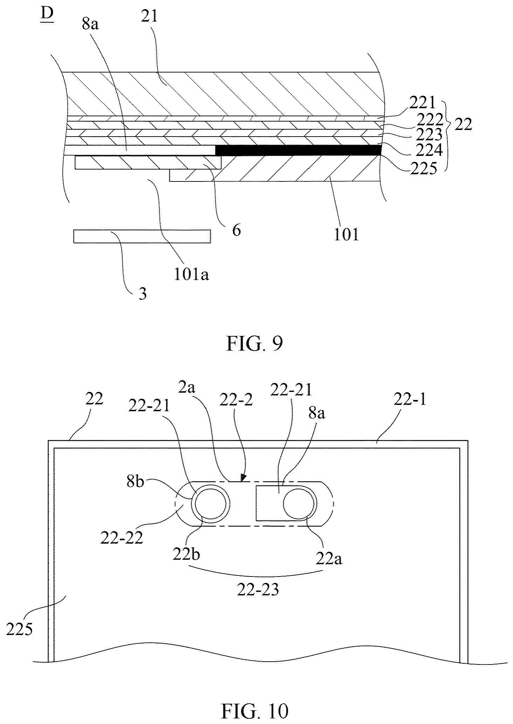

Refer to FIG. 7 to FIG. 9. FIG. 8 is an enlarged schematic diagram of a location C of the structure shown in FIG. 7. FIG. 9 is an enlarged schematic diagram of some components of a structure of a location D in FIG. 8, to show a relative location relationship of the display screen, the ambient light sensor 3, and a light homogenizing plate 6.

To further expand the field of view of the ambient light sensor 3, in this embodiment of this application, the electronic device 100 may further be provided with the light homogenizing plate 6. The light homogenizing plate 6 is located between the second body portion 22-2 and the ambient light sensor 3. A function of the light homogenizing plate 6 is to evenly emit external light entering the second body portion 22-2 to a side of the ambient light sensor 3.

After entering through the first subregion 22-21, the external light is projected on a surface of a side of the light homogenizing plate 6 facing the display module 22. Then, the light homogenizing plate 6 evenly disperses the external light, to obtain a large light outlet surface on a side of the light homogenizing plate 6 facing the ambient light sensor 3, thereby expanding the field of view of the ambient light sensor 3, and further improving reliability of detecting the external light by the ambient light sensor 3.

A thickness of the light homogenizing plate 6 may be as small as possible, to reduce occupied space, thereby facilitating mounting of another electronic component inside the electronic device 100, and satisfying a requirement for lightening and thinning design of the electronic device 100. In an example, the light homogenizing plate 6 is a light homogenizing film. The light homogenizing film may be adhered to be fixed to the middle frame 1. The fixing is simple and reliable. The light homogenizing plate 6 may be as close to a side of the display module 2 as possible.

Certainly, the light homogenizing plate 6 may also be fixed to a back side of the display module 22.

Refer to FIG. 9 for understanding. In this embodiment of this application, a back side of a back plane 224 in the display module 22 may further be provided with an SCF layer 225. The SCF layer 225 is a composite film formed by froth, foam, and copper foil, and can quickly transmit heat generated during operation of the display module 22 to the display module 22. The back side of the substrate 224 is a side facing away from the transparent cover plate 21. The SCF layer 225 may be fixed to the back plane 224 of the display module 22 through an adhesive. For a structure in which the SCF layer 225 is arranged on the back side of the display module 22, because a light transmittance effect of the SCF layer 225 is poor, a first through hole 8a is provided in at least a partial region of the SCF layer 225 corresponding to the second body portion 22-2, so that the external light is projected onto the light homogenizing plate 6. The light homogenizing plate 6 is located between the first through hole 8a and the ambient light sensor 3.

A size and a shape of the first through hole 8a may be determined according to a specific situation. Usually, a cross section of the first through hole 8a is not larger than a projection of the second body portion 22-2 onto the transparent cover plate 21. As shown in FIG. 10, FIG. 10 is a view from a side of the SCF layer, in which only a structure near a relative location of the SCF layer 225 and the second body portion 22-2 is shown and other locations are not shown. Division of the first subregion 22-21, the second subregion 22-22, and the third subregion 22-23 in the second body portion 22-2 may be further understood in FIG. 10. The first subregion 22-21 is a region in the second body portion 22-2 that does not include the SCF layer 225, the second subregion 22-22 is a region in the second body portion 22-2 that includes the SCF layer 225, and the third subregion 22-23 is a location in which the first hole 22a and the second hole 22b are provided. In this embodiment of this application, if there is a requirement for arranging another electronic component of the electronic device 100, a through hole may also be provided at another location of the SCF layer 225.

Refer to FIG. 8 and FIG. 9 for understanding again. In this embodiment of this application, the support plate 101 of the middle frame 1 is located between the display module 22 and the ambient light sensor 3. The support plate 101 may isolate the display screen 2 from another electronic component in the cavity 1a. To be specific, the support plate 101 divides the cavity 1a into two cavities. The display screen 2 is mounted in one cavity, and the another electronic component of the electronic device 100 is mounted in the other cavity. The display screen 2 and the another electronic component may be respectively located in independent cavities, to reduce mutual impact during operation. FIG. 10 shows that the middle frame 1 is further provided with a step surface 1-1, and the transparent cover plate 21 may be supported on the step surface 1-1.

Refer to FIG. 9 for understanding. A second through hole 101a is provided on the support plate 101, and the external light entering through the second body portion 22-2 is transmitted to the ambient light sensor 3 through the second through hole 101a.

In this embodiment of this application, the support plate 101 is arranged, to facilitate mounting of another component of the electronic device 100.

Refer to FIG. 7, FIG. 11, and FIG. 12 again. In this embodiment of this application, the electronic device 100 further includes a plurality of functional module units, configured to implement various functions. The functional module units include an optical component. For example, the optical component in the functional module units may be a front-facing camera 53, configured to implement a photo or video function, or the optical component in the functional module units includes a soft light 51, mainly configured to process light for taking photos to improve quality of the photos. Certainly, the functional module units are not limited to the descriptions herein, and may also be modules implementing other functions.

Usually, the functional module units such as the front-facing camera 53 and the soft light 51, have a high requirement on the light transmittance of the display screen 2. Therefore, the display module 22 needs to be provided with a third through hole to satisfy a requirement that light passes through, that is, the display screen 2 also does not have an image displaying function in a region near the front-facing camera 53 and the soft light 51.

In this embodiment of this application, locations of the functional module units such as the front-facing camera 53 and the soft light 51 and a location of the ambient light sensor 3 may also be optimized, to facilitate design of the display screen 2. Embodiments of this application further describe the technical solutions and the technical effects by using an example in which the electronic device 100 has one front-facing camera 53 and one soft light 51.

Refer to FIG. 4, FIG. 7, and FIG. 8 again. In this embodiment of this application, the soft light 51, the front-facing camera 53, and the ambient light sensor 3 are arranged in parallel along a specified direction S. In this embodiment of this application, the specified direction S is a width direction (a left-right direction shown in FIG. 3) of the electronic device 100. Certainly, the specified direction S may alternatively be another direction parallel to the plane of the display screen 2, for example, a length direction of the electronic device 100, or a direction not set at 90° to the width direction.

Refer to FIG. 8 again. The first hole 22a (namely, the foregoing third through hole) is provided on the second body portion 22-2, the support plate 101 is further provided with a light guide structure 52, the light guide structure 52 is located between the first hole 22a and the soft light 51, and light emitted by the soft light 51 is transmitted to the soft light 51 after passing through the light guide structure 52. The second hole 22b (that is, the foregoing third through hole) is further provided on the second body portion 22-2, the front-facing camera 53 is arranged opposite to the second hole 22b, and the external light enters the front-facing camera 53 through the transparent cover plate 21 and the second hole 22b for imaging.

Compared with that the soft light 51, the front-facing camera 53, and the ambient light sensor 3 are dispersedly arranged at different locations of the electronic device 100, in this embodiment of this application, the soft light 51, the front-facing camera 53, and the ambient light sensor 3 are arranged at a back side of the second body portion 22-2 in a centralized manner, so that an area of the second body portion 22-2 can be reduced as much as possible, and a display area of the first body portion 22-1 can be improved, thereby improving a display capability of the electronic device 100, and facilitating improvement of an overall appearance of the electronic device 100.

To reduce impact of the light emitted by the soft light 51 during operation on the ambient light sensor 3 as much as possible, the following arrangements are further provided in embodiments of this application.

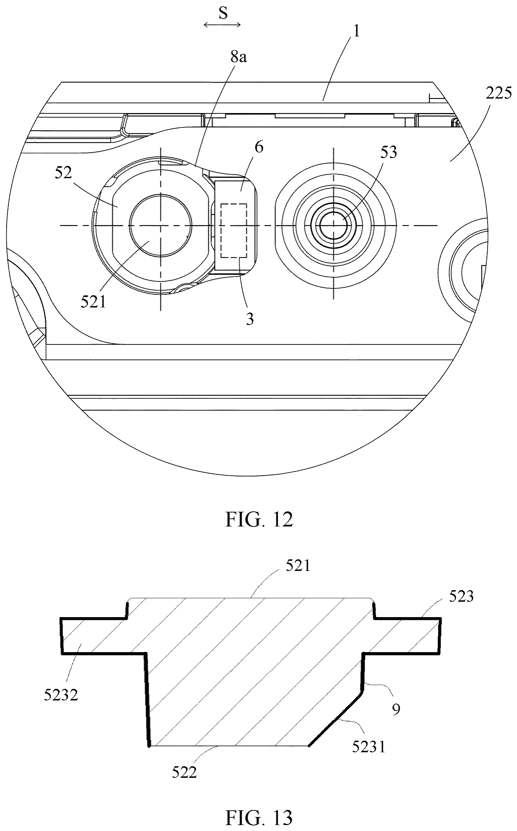

Refer to FIG. 8 and FIG. 13 for understanding. FIG. 13 is a sectional view of a light guide structure and a shielding member in FIG. 3. In this embodiment of this application, the light guide structure 52 includes a first end surface 521, a second end surface 522, and a peripheral side wall 523 connected between the first end surface 521 and the second end surface 522. The first end surface 521 and the second end surface 522 respectively face the first hole 22a and the soft light 51. The peripheral side wall 523 is provided with a light-shielding member 9, configured to block light emitted to or emitted out of the first hole 22a from being transmitted to the ambient light sensor 3. In this embodiment, the light-shielding member 9 is a light-shielding material layer painted on or adhered to the peripheral side wall 523. An arrangement location of the light-shielding material layer on the peripheral side wall 53 is based on that the light emitted by the soft light 51 is not transmitted to the ambient light sensor 3. Certainly, for ease of processing, the light-shielding material layer is arranged on the entire peripheral side wall 523 of a guide structure 52. A material of the light-shielding material layer may be metal or non-metal that can have a light-blocking function, for example, silver or aluminum. In the manner of arranging the light-shielding material layer on the peripheral side wall 523, small space is occupied, and a weight is light, thereby facilitating the lightening and thinning design of the electronic device 100.

In this embodiment of this application, the light-shielding material layer is arranged, so that the light emitted by the soft light 51 can be emitted from the first hole 22a to the outside of the display screen 2, to avoid being transmitted to the ambient light sensor 3, avoid interference of the light emitted by the soft light 51 with the ambient light sensor 3, and improve accuracy of detecting ambient light by the ambient light sensor 3, thereby further improving accuracy of adjusting brightness of the display screen 2.

Certainly, to block the light emitted by the soft light 51 from being transmitted to the ambient light sensor 3, the light-shielding member 9 is not limited to the light-shielding material layer arranged on the foregoing light guide structure 52, and may alternatively have another form. For example, a component such as a light-shielding plate is arranged.

To facilitate mounting of the light guide structure 52, the peripheral side wall 523 further has a protruding portion 5232, and the light guide structure 52 is supported by the support plate 101 through the protruding portion 5232.

In addition, the light guide structure 52 may also have an avoidance structure 5231 to avoid another structure in the cavity 1a, to satisfy a mounting requirement. A specific structure of the light guide structure 52 is not further described herein, provided that the structure can satisfy a use requirement.

In this embodiment of this application, a material of the foregoing light guide structure 52 may be glass or resin. The glass has a high light guide capability, and a resin material is light.

Refer to FIG. 8 again. To enable the light emitted by the soft light 51 to be emitted from the first hole 22a as much as possible, in this embodiment of this application, the first end surface 521 covers the first hole 22a, and the first end surface 521 abuts against and is in contact with the display module 22. The first end surface 521 may directly abut against the display module 22, or may indirectly abut against the display module 22. FIG. 8 shows that the first end surface 521 abuts against the back side of the display module 22 through the SCF layer 225. The first end surface 521 abuts against and is in contact with the display module 22, to prevent light from being leaked between the first end surface 5 and the display module 22, thereby improving working performance of the soft light 51 and also reducing impact on normal operation of another electronic component in the cavity 1a.

Certainly, in addition to the combination of the soft light 51, the front-facing camera 53, and the ambient light sensor 3, two front-facing cameras 53 and the ambient light sensor 3 may be integrally arranged, and the ambient light sensor 3 is arranged between the two front-facing cameras 53. Certainly, a combination of only the soft light 51 and the ambient light sensor 3, or a combination of the front-facing camera 53 and the ambient light sensor 3 may alternatively be arranged.

In addition, the functional module unit may alternatively be a functional module unit other than the soft light 51 and the front-facing camera 53. In conclusion, optical components of the two functional module units and the ambient light sensor are arranged in parallel. In this way, the ambient light sensor can make full use of space between the two optical components, and use the second body portion 22-2 as a light-transmitting region in a centralized manner, so that the second body portion can be as small as possible, thereby further improving an area of the first body portion. In addition, for the structure in which the SCF layer 225 is arranged on the back side of the display module 22, the first through hole 8a on the SCF layer 225 may satisfy requirements of one or more optical components. Certainly, through holes on the SCF layer 225 may alternatively be in a one-to-one correspondence with the optical components and the ambient light sensor 3. The figure shows an embodiment in which the soft light 51 and the ambient light sensor share one first through hole 8a, and the front-facing camera 53 separately corresponds to the other through hole 8b.

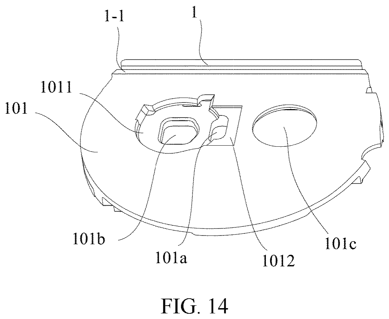

Similarly, an avoidance structure should also be arranged at a relative location of the support plate 101 and the optical component. Refer to FIG. 14. For example, a through hole 101b and a through hole 101c are provided on the support plate 101, for respectively allowing light of the soft light and light of a camera to pass through. To reduce a thickness of the electronic device as much as possible, the support plate 101 may be provided with a counterbore hole for mounting the light guide structure 52 and the light homogenizing plate 6. FIG. 13 shows that a surface of a side of the support plate 101 facing the display screen is provided with a first step surface 1011 for supporting the light guide structure 52, and the support plate 101 is further provided with a second step surface 1012 for supporting the protruding portion 5232 of the light homogenizing plate 6. In this way, the light guide structure 52 and the light homogenizing plate 6 are at least partially located inside the support plate 101, so that mounting heights of the light guide structure 52 and the light homogenizing plate 6 may be reduced.

The optical component is not limited to the soft light 51 and the front-facing camera 53, and may alternatively be another electronic component like a laser-focus sensor and a distance sensor.

The soft light 51 and the ambient light sensor 3 may be fixed to the main board 4. Refer to FIG. 7 again. The middle frame 1 has a supporting base 102, and the main board 4 is fixed to the supporting base 102. A height of the supporting base 102 may be properly arranged according to working requirements of the ambient light sensor 3 and the soft light 51, and another design requirement of the electronic device. In this way, the ambient light sensor and the optical component may directly transmit the optical signal to a main board circuit and do not need to transmit the optical signal through a component like a wire, thereby simplifying a structure.

In this embodiment of this application, under a condition of light having a wavelength of 550 nm (where nm is short for nanometer, which is a length unit), the light transmittance of the second body portion 22-2 approximately ranges from 2% to 4%. In this way, detection on the external light by the ambient light sensor 3 can be satisfied, and the second body portion 22-2 also has a good function of concealing the overall appearance, that is, the electronic component located at the back side of the second body portion 22-2 is not easily observed from the outside of the electronic device 100, and the transparent cover plate 21 does not need to be painted with ink, thereby simplifying the processing process of the electronic device 100, reducing the costs, and providing a good overall appearance of the electronic device.

For other structures of the electronic device 100, refer to the conventional technologies.

In embodiments of this application, terms "first" and "second" are used merely for a purpose of description, and shall not be understood as an indication or implication of relative importance or implicit indication of a quantity of indicated technical features. Therefore, a feature defined with the "first" or the "second" may explicitly or implicitly include one or more features.

Orientation terms, for example, "inner" and "outer", mentioned in embodiments of this application are only directions of the accompanying drawings. Therefore, the orientation terms used are intended to better and more clearly describe and understand embodiments of this application, rather than to indicate or imply that an indicated apparatus or element needs to have a specific orientation, or needs to be constructed and operated in a specific orientation, and therefore cannot be construed as a limitation on embodiments of this application.

In the description of embodiments of this application, terms "include", "comprise", and any variants thereof are intended to cover a non-exclusive inclusion. Therefore, in the context of a process, method, object, or apparatus that includes a series of elements, the process, method, object, or apparatus not only includes such elements, but also includes other elements not specified expressly, or may include inherent elements of the process, method, object, or apparatus.

In embodiments of this application, "and/or" is merely an association relationship describing related objects, which means that three relationships may exist. For example, A and/or B may represent the following three cases. Only A exists, both A and B exist, and only B exists. In addition, the character "/" herein usually represents an "or" relationship between associated objects.

The foregoing descriptions are merely examples of embodiments of this application, and a person of ordinary skill in the art may make various improvements and modifications without departing from the spirit of this application. All such improvements and refinements shall fall within the protection scope of this application.

## Claims

1. An electronic device, comprising the following components:
a middle frame, having a cavity;
a display screen, comprising a transparent cover plate and a display module, wherein the display screen is fixed to a side of the middle frame, the display module comprises a plurality of superposed functional layers, the display module comprises a first body portion and a second body portion that are connected with each other, the first body portion forms a display region, the second body portion forms a non-display region, the second body portion comprises a first subregion, the first subregion comprises at least one of the functional layers, and the first subregion has light transmittance with a predetermined value; and
an ambient light sensor, fixed to the cavity and located at a side of the first subregion facing away from the transparent cover plate, wherein the ambient light sensor is configured to detect external light passing through the first subregion.

2. The electronic device according to claim 1, wherein a projection of at least a part of a photo sensitive element of the ambient light sensor onto a plane of the display screen is located within a range of the first subregion.

3. The electronic device according to claim 2, further comprising a light homogenizing plate, located between the first subregion and the ambient light sensor, wherein the light homogenizing plate is configured to evenly scatter the external light entering the first subregion to a side of the ambient light sensor.

4. The electronic device according to claim 3, wherein the light homogenizing plate comprises a light homogenizing film, and the light homogenizing film is adhered to be fixed to the middle frame or the display module.

5. The electronic device according to claim 3 or 4, wherein the display module further comprises an SCF layer, the SCF layer is located on a surface of the functional layer facing away from the transparent cover plate, a first through hole is provided in at least a partial region of the SCF layer corresponding to the first subregion, and the light homogenizing plate is located between the first through hole and the ambient light sensor.

6. The electronic device according to any one of claims 1 to 5, wherein under a condition of light having a wavelength of 550 nm, the light transmittance of the first subregion ranges from 2% to 4%.

7. The electronic device according to claim 5, wherein the second body portion further comprises a second subregion, and the second subregion comprises the SCF layer and functional layers located between the SCF layer and the transparent cover plate.

8. The electronic device according to any one of claims 1 to 7, wherein the display module is an OLED display module, the functional layers comprise an OLED layer, the OLED layer comprises a first part and a second part that are connected with each other, the first part is provided with a plurality of light-emitting diodes, the first body portion comprises the first part, and the second body portion comprises the second part; and
the second part has no light-emitting diode, or the second part is provided with a light-emitting diode and the light-emitting diode in the second part is always in a non-light-emitting state.

9. The electronic device according to claim 8, wherein the functional layers further comprise one or more of a polarization layer, a touchscreen layer, a thin film field-effect transistor layer, an encapsulation layer, and a substrate.

10. The electronic device according to any one of claims 1 to 9, wherein the middle frame comprises a support plate, the support plate is located between the display module and the ambient light sensor, a second through hole is provided on the support plate, and the external light entering through the first subregion is transmitted to the ambient light sensor through the second through hole.

11. The electronic device according to claim 10, further comprising:
a functional module unit, comprising an optical component, wherein the optical component is fixed to the cavity, the second body portion further comprises a third subregion, the third subregion comprises a third through hole for allowing light transmitted or received by the optical component to pass through, the light source component and the ambient light sensor are arranged in parallel along a specified direction, and the specified direction is parallel to a plane of the transparent cover plate; and
a light-shielding member, configured to block light emitted to or emitted out of the third through hole from being transmitted to the ambient light sensor.

12. The electronic device according to claim 11, wherein the optical component is a light source component, the functional module further comprises a light guide structure, the light guide structure is supported by the support plate, and the light guide structure is located between the light source component and the third through hole, to guide light emitted by the light source component.

13. The electronic device according to claim 12, wherein the light guide structure comprises a first end surface, a second end surface, and a peripheral side wall connecting the first end surface and the second end surface, the first end surface and the second end surface respectively face the third through hole and the light source component, and the light-shielding member comprises a light-shielding material layer arranged on the peripheral side wall.

14. The electronic device according to claim 13, wherein the first end surface covers the third through hole, and the first end surface abuts against and is in contact with the display module.

15. The electronic device according to any one of claims 11 to 14, wherein the cavity further has a main board, and the ambient light sensor and the optical component are mounted on the main board.

16. The electronic device according to claim 14, wherein two functional module units are provided, optical components of the two functional module units are respectively located at two sides of the ambient light sensor, and the optical components and the ambient light sensor are arranged in parallel.

17. The electronic device according to any one of claims 11 to 16, wherein the optical component is at least one of a soft light or a front-facing camera.

18. The electronic device according to any one of claims 1 to 17, wherein the display region is located at a periphery of the non-display region.

19. The electronic device according to claim 18, wherein the non-display region is an oblong or a rectangle.
